# EUROPÄISCHE PATENTSCHRIFT

(11) **EP 1 769 661 B1**
(45) Veröffentlichungstag und Bekanntmachung des Hinweises auf die Patenterteilung: **20.08.2008**
(21) Anmeldenummer: 06763714.0
(22) Anmeldetag: 14.06.2006
(51) Int. Cl.: H05K 13/04

(54) **BESTÜCKSYSTEM UND VERFAHREN ZUM BESTÜCKEN VON SUBSTRATEN MIT ELEKTRISCHEN BAUTEILEN**
LOADING SYSTEM AND METHOD FOR LOADING SUBSTRATES WITH ELECTRICAL COMPONENTS
SYSTEME DE MISE EN PLACE DE COMPOSANTS ET PROCEDE POUR METTRE EN PLACE DES COMPOSANTS ELECTRIQUES SUR DES SUBSTRATS

(30) Priorität: 20.07.2005 DE 102005033979
(43) Veröffentlichungstag der Anmeldung: 04.04.2007
(73) Patentinhaber: SIEMENS AKTIENGESELLSCHAFT, 80333 München (DE)
(72) Erfinder: MEHDIANPOUR, Mohammad, 81829 München (DE)
(86) Internationale Anmeldenummer: PCT/EP2006/063218
(87) Internationale Veröffentlichungsnummer: WO 2007/009848

(56) Entgegenhaltungen:
- EP-A- 0 808 091
- WO-A-03/103363
- DE-A1- 10 156 266
- DE-A1- 19 707 267
- DE-B3- 10 336 609

## Beschreibung

Die Erfindung betrifft ein Bestücksystem zum Bestücken von Substraten mit elektrischen Bauteilen sowie ein entsprechendes Verfahren unter Verwendung des Bestücksystems.

Aus der WO 03/103363 ist ein Bestücksystem bekannt, welches einen Trägerarm mit zwei daran in einem festen Abstand zueinander befestigten Bestückeinrichtungen aufweist. Der Trägerarm ist entlang eines Führungsbalkens in einer Transportrichtung von zu bestückenden Substraten verfahrbar. Der Führungsbalken ist an seinen beiden Enden an zwei stationären Grundträgern senkrecht zur Bewegungsrichtung des Trägerarmes verfahrbar gelagert.

Das oben genannte Bestücksystem weist jedoch durch die beidseitige Lagerung des Führungsbalkens den Nachteil auf, dass im Falle eines einseitigen Antriebs des Führungsbalkens eine schnelle und exakte Positionierung der Bestückeinrichtungen über den Substraten nur sehr schwer möglich ist, wogegen ein beidseitiger Antrieb des Führungsbalkens einen erhöhten konstruktiven, finanziellen und steuerungstechnischen Aufwand mit sich bringt. Ferner führt die Verwendung größerer Substrate zu einer größeren freien Länge des Führungsbalkens, was bei einem schweren, mittig angeordneten Trägerarm eine höhere Schwingungsneigung zur Folge hat.

Es ist deshalb die Aufgabe der vorliegenden Erfindung, ein Bestücksystem mit einem einfachen konstruktiven Aufbau und hoher Bestückgenauigkeit, sowie ein Bestückverfahren unter Verwendung dieses Bestücksystems zu liefern.

Diese Aufgabe wird durch das Bestücksystem gemäß Anspruch 1 sowie das Bestückverfahren gemäß Anspruch 11 gelöst. Vorteilhafte Ausgestaltungen des Bestücksystems bzw. des Verfahrens sind Gegenstand der abhängigen Ansprüche.

Ein Bestücksystem zum Bestücken von Substraten mit elektrischen Bauteilen gemäß dem unabhängigen Anspruch 1 weist mindestens eine Transportstrecke, mittels der ein erstes und ein zweites Substrat in einer Transportrichtung transportierbar sind, einen Grundträger, einen ersten Trägerschlitten, welcher an dem Grundträger in einer Verschieberichtung verschiebbar gelagert ist, einen lang gestreckten ersten Trägerarm, dessen Längsachse quer zur Verschieberichtung orientiert ist und welcher an dem ersten Trägeschlitten in der Richtung seiner Längsachse verschiebbar gelagert ist, und einen ersten Bestückkopf und einen zweiten Bestückkopf zum Bestücken von zumindest einem der ersten und zweiten Substrate, wobei der erste Bestückkopf und der zweite Bestückkopf in Richtung der Längsachse des ersten Trägerarmes auf gegenüberliegenden Seiten des Trägeschlittens in einem festen Abstand zueinander am ersten Trägerarm angeordnet sind, auf. Bei dem so ausgebildeten Bestücksystem ist für jede Bewegungsrichtung der Bestückköpfe jeweils nur ein Antrieb notwendig. Einmal für die Bewegung des ersten Trägerschlittens entlang des Grundträgers und einmal für den ersten Trägerarm entlang das ersten Trägerschlittens. Da der erste Trägerarm zwei freie Enden aufweist und dazwischen an dem ersten Trägerschlitten gelagert ist, ergibt sich die freie Länge des ersten Trägerarms auf beiden Seiten des ersten Trägerschlittens jeweils als der Abstand zwischen dem jeweiligen freien Ende des ersten Trägerarms und dem ersten Trägerschlitten. Werden also zwei Substrate durch den ersten und zweiten Bestückkopf bestückt, ist die freie Länge des ersten Trägerarm auf beiden Seiten des ersten Trägerschlittens deutlich geringer als die freie Länge des beidseitig gelagerten Führungsbalkens des aus dem Stand der Technik bekannten Bestücksystems, da sich hier die freie Länge aus der Gesamtlänge des Führungsbalkens bestimmt. Dadurch ergibt sich eine deutlich verringerte Schwingungsneigung, was ein schnelleres und präziseres Positionieren der Bestückköpfe ermöglicht.

Ferner kann die Breite des Lagers, an dem der erste Trägerarm am ersten Trägerschlitten geführt ist, in Richtung der Längsachse des ersten Trägerarmes nach Bedarf entsprechend groß dimensioniert werden, so dass eine sehr stabile Lagerung erzielbar ist.

Der Aufbau erlaubt für die Bestückung von zwei Substraten einen höchstmöglichen Parallelisierungsgrad aller zum Bestücken notwendigen Vorgänge. Da auf beiden Seiten des Trägerarmes Bestückköpfe vorgesehen sind, wirken diese gegenseitig als Gewichtausgleich, was insbesondere beim schnellen Positionieren Vorteile mit sich bringt.

Nach einer Ausgestaltung des Bestücksystems nach Anspruch 2 ist der erste und der zweite Bestückkopf jeweils derart ausgebildet und derart am Trägerarm angeordnet, dass das erste Substrat von dem ersten Bestückkopf und das zweite Substrat von dem zweiten Bestückkopf zur Bildung gleicher Baugruppen mit gleichen Bauteilen gleichzeitig bestückbar ist. Bei dem ersten und zweiten Substrat handelt es sich dabei um Substrate gleichen Typs, welche auf jeweils entsprechend gleichen Positionen mit gleichen Bauteilen zu bestücken sind. Der erste und zweite Bestückkopf sind derart an dem Trägerarm angebracht und derart ausgebildet, dass sie zu dem jeweils zugeordneten Substrat gleichzeitig dieselbe relative Lage einnehmen und dieses an den jeweils entsprechend gleichen Positionen mit gleichen Bauteilen bestücken können. Durch die gleichzeitige Bestückung ergibt sich aufgrund der verminderten Anzahl von Verfahrvorgängen eine hohe Effizienz des Bestückvorganges.

In einer Ausgestaltung des Bestücksystems nach Anspruch 3 überspannt der Grundträger die Transportstrecke quer, wobei die Verschieberichtung des ersten Trägerschlittens quer zur Transportrichtung gerichtet ist und der erste Trägerarm parallel zur Transportrichtung verschiebbar gelagert ist. Diese Ausführungsform erweist sich als günstig für das schnelle Bestücken von zwei Substraten, welche hintereinander auf derselben Transportstrecke transportiert werden.

Das Bestücksystem kann auch dahingehend ausgestaltet werden, dass gemäß Anspruch 4 der erste Bestückkopf und der zweite Bestückkopf jeweils an den Stirnseiten des ersten Trägerarmes angeordnet sind. Durch diese symmetrische Anordnung ergeben sich besonders geringe Torsionskräfte auf den ersten Trägerarm.

Zusätzlich können der erste und zweite Bestückkopf gemäß dem Anspruch 5 jeweils mit einer Führungseinrichtung versehen werden, mittels der der erste und zweite Bestückkopf ein jeweils zugeordnetes Substrat auf eine vorgegebene Position, wie beispielsweise die Bestückposition, entlang der Transportstrecke führen können. Dadurch, dass die Bestückköpfe in einem festen definierten Abstand zueinander am ersten Trägerarm angeordnet sind, ist es durch die Führungseinrichtungen möglich, auch die Substrate in eine exakte relative Position zum jeweils zugeordneten Bestückkopf zu positionieren.

Gemäß dem Anspruch 6 können die Führungseinrichtungen über Halteeinrichtungen, wie beispielsweise Saugnäpfe oder Greifer, verfügen, mit welchen die Substrate lösbar aber fest von den Führungseinrichtungen gehalten werden können.

Das Bestücksystem kann gemäß Anspruch 7 dahingehend ausgestaltet werden, dass an dem Trägerarm mehrere Funktionseinheiten, wie beispielsweise Kameras, Klebeeinrichtungen oder auch zusätzliche Bestückköpfe vorgesehen sind. Dadurch wird die Flexibilität des Bestückvorganges weiter erhöht.

Das Bestücksystem kann gemäß Anspruch 8 über eine Vielzahl von Zuführeinrichtungen zum Zuführen elektrischer Bauteile verfügen, wobei die Zuführeinrichtungen derart entlang der Transportstrecke angeordnet sind, dass die elektrischen Bauteile durch den ersten und zweiten Bestückkopf gleichzeitig von den Zuführeinrichtungen abgeholt werden können. Die dem jeweiligen Bestückkopf zugeordneten Zuführeinrichtungen sind dabei in demselben Raster aufgerüstet und derart beabstandet, dass durch das gleichzeitige Abholen der Bauteile der Abholvorgang sehr schnell durchgeführt werden kann.

In einer Ausgestaltung umfasst das Bestücksystem gemäß Anspruch 9 einen zweiten Trägerschlitten, welcher am Grundträger in der Verschieberichtung verschiebbar gelagert ist, einen lang gestreckten zweiten Trägerarm, dessen Längsachse quer zur Verschieberichtung orientiert ist und welcher an dem zweiten Trägeschlitten in Richtung seiner Längsachse verschiebbar gelagert ist, und einen dritten und einen vierten Bestückkopf, welche in Richtung der Längsachse des zweiten Trägerarmes auf gegenüberliegenden Seiten des zweiten Trägerschlittens in einem festen Abstand zueinander am zweiten Trägerarm angeordnet sind. Durch das Vorsehen zweier weiterer Bestückköpfe, welche unabhängig von dem ersten und dem zweiten Bestückkopf entlang des Grundträgers bewegt werden können, kann die Bestückleistung und die Flexibilität des Bestücksystems weiter erhöht werden.

In einer weiteren Ausgestaltung des Bestücksystems nach Anspruch 10 wird der erste Trägerschlitten mittels eines ersten Linearmotors und der zweite Trägerschlitten mittels eines zweiten Linearmotors entlang des Grundträgers bewegt, wobei der Grundträger Permanentmagnete als gemeinsame Stationärteile für den ersten und den zweiten Linearmotor aufweist. Durch die Zusammenfassung von Baugruppen des ersten und zweiten Linearmotors können Kosten reduziert und der konstruktive Aufwand verringert werden.

Ein Verfahren zum Bestücken von Substraten mit elektrischen Bauteilen gemäß dem Anspruch 11 weist sich dadurch aus, dass es unter Verwendung des Bestücksystems nach einem der Ansprüche 1 bis 8 durchgeführt wird. Dabei werden Handhabungsvorgänge für die Bauteile durch Greifereinheiten des ersten und zweiten Bestückkopfs durchgeführt. Bezüglich der Vorteile, welche die Verwendung des erfindungsgemäßen Bestücksystems für die Durchführung des Verfahrens bringen, wird auf die Ausführungen bezüglich der Ansprüche 1 bis 8 verwiesen. Insbesondere ist jedoch darauf hinzuweisen, dass durch die Verwendung des erfindungsgemäßen Bestücksystems die Handhabungsvorgänge für die Bauteile mittels der jeweiligen Greifereinheiten gleichzeitig, synchron oder anderweitig zeitlich korreliert durchgeführt werden können, was den Parallelisierungsgrad der Bestückvorgänge erhöht und den dafür nötigen Zeitaufwand möglichst klein hält.

In einer Ausgestaltung des Verfahrens gemäß Anspruch 12 ist das erste Substrat dem ersten Bestückkopf und das zweite Substrat dem zweiten Bestückkopf zugeordnet, und das erste Substrat wird mittels einer Greifereinheit des ersten Bestückkopfs und das zweite Substrat mittels einer Greifereinheit des zweiten Bestückkopfes zur Bildung gleicher Baugruppen mit gleichen Bauteilen gleichzeitig bestückt. Wie bezüglich des Anspruchs 2 schon erwähnt, ergeben sich durch gleichzeitiges Bestücken von zwei Substraten erhebliche Zeitvorteile bzw. eine Verkürzung des Bestückvorganges. Das gleichzeitige Bestücken zweier Substrate mittels der beiden Bestückköpfe setzt jedoch voraus, dass die relativen Positionen der Bestückköpfe bzw. deren Greifereinheiten zu dem jeweils zugeordneten Substrat gleich sind.

In dem Fall, dass die Substrate bezüglich ihrer jeweils zugeordneten Bestückköpfe nicht in der gleichen relativen Lage positionierbar sind, ist es möglich, dass zumindest eine Greifereinheit des ersten Bestückkopfes und eine Greifereinheit des zweiten Bestückkopfes das jeweils zugeordnete Substrat zur Bildung gleicher Baugruppen mit gleichen Bauteilen unmittelbar aufeinander folgend bestücken. In diesem Fall sind die Substrate entsprechend der Möglichkeiten der jeweils im Bestücksystem verwendeten Transporteinrichtung soweit wie möglich in eine gleiche relative Lage bezüglich der jeweils zugeordneten Bestückköpfe zu positionieren. Dadurch, dass eine Greifereinheit des ersten Bestückkopfes und unmittelbar darauf eine Greifereinheit des zweiten Bestückkopfes das jeweils zugeordnete Substrat an der jeweils entsprechend gleichen Position mit gleichen Bauteilen bestückt, ergeben sich nur äußerst geringe Verfahrwege und eine äußerst kurze Zeitspanne zwischen den einzelnen Bestückvorgängen. Man kann dieses Verfahren deswegen auch als quasi gleichzeitiges Bestücken bezeichnen.

Gemäß einer Ausgestaltung des Verfahrens nach Anspruch 14 werden zwischen dem Bestückvorgang der Greifereinheit des ersten Bestückkopfes und dem Bestückvorgang der Greifereinheit des zweiten Bestückkopfes unmittelbar nach dem Freigeben des Bauteiles durch die Greifereinheit des ersten Bestückkopfes beide Bestückköpfe um diesen geringen Korrekturbetrag bewegt. Die Korrekturbewegung wird daher sobald als möglich nach dem Aufsetzen und Freigeben des Bauteils durch die Greifereinheit des ersten Bestückkopfes durchgeführt, um möglichst wenig Zeit zu verlieren.

Um den zeitlichen Abstand zwischen den Bestückvorgängen der ersten Greifereinheit des ersten Bestückkopfes und der Greifereinheit des zweiten Bestückkopfes noch weiter zu vermindern, kann die Korrekturbewegung gemäß Anspruch 15 schon dann durchgeführt werden, während die Greifereinheit des ersten Bestückkopfes entgegen der Bestückrichtung relativ zu dem Gehäuse des ersten Bestückkopfes bewegt wird. Die Korrekturbewegung beginnt daher schon beim Hochziehen des Greifers des ersten Bestückkopfes.

Zur weiteren Beschleunigung des Bestückvorganges kann gemäß Anspruch 16 die Greifereinheit des zweiten Bestückkopfes schon während der Korrekturbewegung in eine Bestückrichtung relativ zu dem Gehäuse des zweiten Bestückkopfes bewegt werden. Durch die Absenkung der Greifereinheit des zweiten Bestückkopfes noch vor Erreichen der Bestückposition, wird der Weg, den die Greifereinheit zum Aufsetzen des Bauteiles auf dem zweiten Substrat zurückzulegen hat, bis zu einem geringen Wert minimiert.

Der Abholvorgang, d. h. das Abholen der Bauteile von Zuführeinrichtungen des Bestücksystems durch die Greifereinheiten des ersten und zweiten Bestückkopfes, kann dahingehend optimiert werden, dass die Greifereinheit die Bauteile gleichzeitig abholen.

Gemäß einer Ausgestaltung des Verfahrens nach Anspruch 18 werden das erste Substrat und das zweite Substrat entlang der Transportstrecke in einer Transportrichtung transportiert und gleichzeitig der erste und zweite Bestückkopf in Transportrichtung bewegt. Noch während die Substrate und die Bestückköpfe in Transportrichtung bewegt werden, werden eine erste Führungseinrichtung, welche am ersten Bestückkopf vorgesehen ist, mit dem ersten Substrat und eine zweite Führungseinrichtung, welche an dem zweiten Bestückkopf vorgesehen ist, mit dem zweiten Substrat jeweils derart in Kontakt gebracht, dass das erste Substrat von der ersten Führungseinrichtung und das zweite Substrat von der zweiten Führungseinrichtung zu einer vorgegebenen Position entlang der Transportstrecke geführt werden. Sobald das erste Substrat und das zweite Substrat die jeweils vorgegebene Position erreicht haben, werden das erste Substrat mittels der ersten Führungseinrichtung und das zweite Substrat mittels der zweiten Führungseinrichtung gestoppt. Durch die an den Bestückköpfen vorgesehenen Führungseinrichtungen ist es somit möglich, die Substrate mit großer Genauigkeit und in einem sehr genau definierten Abstand zueinander an gewünschten Positionen entlang der Transportstrecke zu positionieren. Dadurch, dass die Führungseinrichtungen mit den Substraten in Kontakt gebracht werden, während sowohl die Bestückköpfe als auch die Substrate entlang der Transportstrecke in Transportrichtung bewegt werden, ist die Relativbewegung zwischen den Führungseinrichtungen und den Substraten im Moment des Kontakts sehr gering, wodurch die Aufprallgeschwindigkeit im Moment des Kontakts auf ein Minimum reduziert werden kann. Dadurch ist es gemäß einer Ausgestaltung nach Anspruch 19 auch möglich, dass die Greifereinheiten der Bestückköpfe selbst als Führungseinrichtungen fungieren. Eine Beschädigung der Greifereinheiten kann dadurch verhindert werden. Falls die Greifereinheiten auch gleichzeitig die Funktion der Führungseinrichtungen übernehmen, kann auf zusätzliche konstruktive Maßnahmen am Bestückkopf verzichtet werden.

Gemäß einer Ausgestaltung nach Anspruch 20 fungieren solche Greifereinheiten des ersten und zweiten Bestückkopfs als Führungseinrichtungen, die anschließend das erste und zweite Substrat zur Bildung gleicher Baugruppen mit gleichen Bauteilen bestücken. Vorteilhafterweise werden dabei die Greifereinheiten an entsprechend gleichen Stellen der beiden Substrate in Kontakt gebracht, so dass die mit gleichen Bauteilen zu bestückenden Positionen auf den Substraten jeweils denselben Abstand haben wie die Greifereinheiten an dem ersten und zweiten Bestückkopf, wodurch ein gleichzeitiges Bestücken oder auch ein quasi gleichzeitiges Bestücken möglich wird.

Das Verfahren kann gemäß Anspruch 21 auch dahingehend ausgestaltet werden, dass der erste Trägerarm vor einem Verschieben des ersten Trägerschlittens derart an dem ersten Trägerschlitten verschoben wird, dass die Abstände zweier freier Enden des ersten Trägerarmes zu dem ersten Trägerschlitten gleich sind. Dadurch wird ein möglichst exakter Gewichtsausgleich auf beiden Seiten des Trägerschlittens erzielt, was Vorteile beim schnellen Verfahren mit sich bringt.

Bei der Ausgestaltung des Verfahrens nach Anspruch 22 wird unter Verwendung einer speziellen Ausführungsform des Bestücksystems durchgeführt, bei dem der Grundträger die Transportstrecke quer überspannt, die Verschieberichtung des ersten Trägerschlittens quer zur Transportrichtung gerichtet ist und der erste Trägerarm parallel zur Transportrichtung verschiebbar gelagert ist, wobei der in Transportrichtung stromaufwärts angeordnete Bestückkopf die kleineren Bauteile handhabt wie der in Transportrichtung stromabwärts angeordnete Bestückkopf. Dadurch, dass die großen Bauteile von dem stromabwärts angeordneten Bestückkopf gehandhabt werden, wird verhindert, dass die größeren Bauteile von dem stromabwärts angeordneten Bestückkopf beschädigt oder umgeworfen werden würde.

Im Folgenden wird die Erfindung anhand eines Ausführungsbeispieles unter Bezug auf die beigefügten Figuren näher erläutert. In den Figuren sind:
Figur 1a eine schematische Querschnittsansicht eines Ausführungsbeispiels des erfindungsgemäßen Bestücksystems entlang der Schnittlinie A-A in Figur 1b;
Figur 1b eine schematische Draufsicht auf das erfindungsgemäße Bestücksystem;
Figuren 2a und 2b schematisch dargestellte Ausführungsformen einer Führungseinrichtung des erfindungsgemäßen Bestücksystems;
Figuren 3a bis 3c schematische Darstellungen eines Vorgangs eines Bestückverfahrens unter Verwendung des erfindungsgemäßen Bestücksystems;
Figuren 4a und 4b eine schematische Darstellung einer alternativen Ausgestaltung des erfindungsgemäßen Bestücksystems;
Figur 5 eine weitere alternative Ausgestaltung des erfindungsgemäßen Bestücksystems.

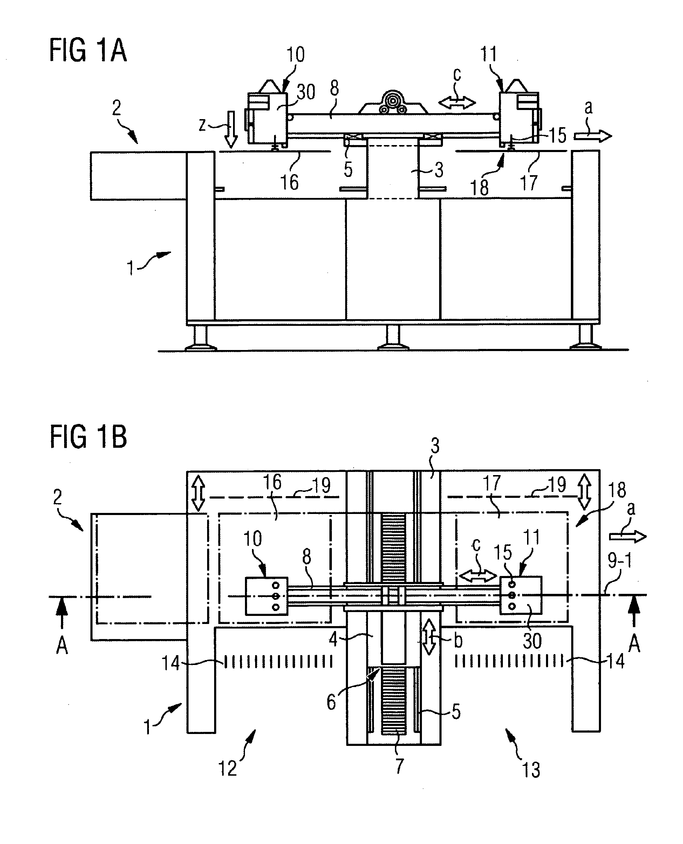

In den Figuren 1a und 1b ist ein Ausführungsbeispiel des erfindungsgemäßen Bestücksystems schematisch dargestellt. Das Bestücksystem weist ein Chassis 1 auf, über welches eine Transportstrecke 2 zum Transport von Substraten in einer Transportrichtung (Pfeil a) verlegt ist. Dabei kann es sich beispielsweise um ein einfaches Transportband mit einem Antriebsmechanismus handeln. Ein Grundträger 3 des Bestücksystems ist so angeordnet, dass er die Transportstrecke 2 brückenartig quer zur Transportrichtung überspannt. Ein erster Trägerschlitten 4 ist in einer Verschieberichtung (Pfeil b), welche quer zur Transportrichtung gerichtet ist, verschiebbar am Grundträger 3 angeordnet. Dabei wird der erste Trägerschlitten 4 mittels geeigneter Linearführungen 5 entlang dem Grundträger 3 geführt und beispielsweise mittels eines ersten Linearmotors 6 angetrieben. Permanentmagnete 7 sind als Stationärteile des ersten Linearmotors 6 am Grundträger 3 angebracht, wobei sich die mobilen Spulenteile (nicht dargestellt) am ersten Trägerschlitten 4 befinden. Ein lang gestreckter erster Trägerarm 8 mit einer in der Transportrichtung der Substrate gerichteten Längsachse 9-1 ist in Richtung seiner Längsachse 9-2, d.h. in einer zur Transportrichtung parallelen Richtung (Pfeil c), verschiebbar am ersten Trägerschlitten 4 angebracht. Der Antrieb kann auch in diesem Fall mittels eines weiteren Linearmotors (nicht dargestellt) erfolgen. Der erste Trägerarm 8 kann dabei als einfaches Vierkantrohr ausgebildet sein, welches in einer U-förmigen Führung auf Seiten des ersten Trägerschlittens 4 geführt wird. Die Ausbildung als Vierkantrohr erweist sich hinsichtlich der Kosten, der Stabilität und des Gewichts als vorteilhaft. Am ersten Trägerarm 8 sind entlang seiner Längsachse 9-1 an gegenüberliegenden Seiten des ersten Trägerschlittens 4 ein erster und zweiter Bestückkopf 10, 11 in einem festen Abstand zu einander angeordnet. Im Ausführungsbeispiel der Figuren 1a und 1b sind der erste und zweite Bestückkopf 10, 11 jeweils an den Stirnseiten des ersten Trägerarms 8 angebracht. Aufgrund dieser symmetrischen Anordnung des ersten und zweiten Bestückkopfes 10, 11 wirken diese beim Verfahren des ersten Trägerschlittens 4 als Gegengewichte auf beiden Seiten, was die Lagerbelastung des ersten Trägerarmes 8 beim abrupten Anhalten verringert. Durch die Anordnung des ersten und zweiten Bestückkopfes 10, 11 an den Stirnseiten des ersten Trägerarmes 8 ergibt sich ferner eine geringe Torsionsneigung.

Ein Vorteil dieser Anordnung des Grundträgers 3 ist, dass seine Breite in Richtung der Transportrichtung beliebig dimensioniert werden kann, so dass auch die höchsten Anforderungen an die Steifigkeit des Systems erfüllt werden können. Die in den Figuren 1a und 1b dargestellte Konstruktion erweist sich auch hinsichtlich der Einleitung der Kräfte um Momente, welche beim Verfahren des ersten Trägerarmes 8 und des ersten Trägerschlittens 4 verursacht werden, in das Chassis 1 als äußerst günstig.

Auf zumindest einer Seite der Transportstrecke 2 sind in einem ersten Abholbereich 12, welcher dem ersten Bestückkopf 10 zugeordnet ist, und einem zweiten Abholbereich 13, welcher dem zweiten Bestückkopf 11 zugeordnet ist, jeweils eine Vielzahl von Zuführeinrichtungen 14 angeordnet. Die Zuführeinrichtungen 14 sind derart ausgestaltet, dass sie die elektrischen Bauteile mit hoher Präzision an eine Abholposition, von der der Bestückkopf das Bauteil aufnimmt, zuführen können.

Wie aus den Figuren 1a und 1b ferner hervorgeht, weisen beide Bestückköpfe 10, 11 jeweils eine Mehrzahl an Greifereinheiten 15 auf, welche relativ zu einem Gehäuse 30 des jeweiligen Bestückkopfs 10, 11 in einer Bestückrichtung (Pfeil z), welche senkrecht zur Substratoberfläche gerichtet ist, beweglich am Bestückkopf 10, 11 gelagert sind. Bei den Greifereinheiten 15 kann es sich um Sauggreifer handeln, welche auf ihrer dem Substrat zugewandten Seite eine Saugöffnung aufweisen, die wahlweise mit Unterdruck zum Aufnehmen von Bauteilen als auch mit Überdruck zum Absetzen der Bauteile auf dem Substrat beaufschlagt werden können. Aus Figur 1b wird deutlich, dass die Greifereinheiten 15 des ersten und zweiten Bestückkopfes 10, 11 paarweise auf zur Längsachse 9-1 des ersten Trägerarmes 8 bzw. zur Transportrichtung parallelen Linien angeordnet sind. Im Folgenden werden diese Paare von Greifereinheiten 15 als "sich entsprechende Greifereinheiten 15" des ersten und zweiten Bestückkopfes 10, 11 bezeichnet.

Im Folgenden wird eine erste Ausgestaltung des erfindungsgemäßen Verfahrens zum Bestücken von Substraten mit elektrischen Bauteilen unter Verwendung des oben beschriebenen Bestücksystems näher erläutert. Das Verfahren zeichnet sich dadurch aus, dass zwei gleichartige Substrate von dem ersten und zweiten Bestückkopf 10, 11 mit gleichen Bauteilen zur Bildung gleicher Baugruppen bestückt werden. Unter einer Baugruppe ist gemäß Definition ein in sich geschlossener, aus zwei oder mehr Teilen und/oder Baugruppen niederer Ordnung bestehender Gegenstand zu verstehen, wobei ein Teil ein technisch beschriebener, nach einem bestimmten Arbeitsablauf zu fertigender bzw. gefertigter, nicht zerlegbarer Gegenstand ist (DIN 6789 Dokumentationssystematik). In diesem Fall sind die nicht zerlegbaren Gegenstände die elektrischen Bauteile, mit welchen die Substrate bestückt werden. Unter den Baugruppen ist im vorliegenden Fall eine zu fertigende Funktionseinheit bestehend aus mehreren zusammenwirkenden Bauteilen zu verstehen.

Durch die oben beschriebene Ausgestaltung und Anordnung der Bestückköpfe 10, 11 am ersten Trägerarm 8 sowie die gegenseitige Lage der jeweils zugeordneten Greifereinheiten 15 des ersten und zweiten Bestückkopfes 10, 11 zueinander können gleichartige Substrate vom ersten und zweiten Bestückkopf 10, 11 zur Bildung gleicher Baugruppen mit gleichen Bauteilen gleichzeitig bestückt werden.

Wie oben erwähnt, sind die Zuführeinrichtungen 14 derart ausgebildet, dass sie die von den Bestückköpfen 10, 11 abzuholenden Bauteile exakt an eine Abholposition befördern können. Im Ausführungsbeispiel sind die Zuführeinrichtungen 14 im ersten und zweiten Abholbereich 12, 13 im gleichen Raster aufgerüstet. Ferner liegen die Abholpositionen der Zuführeinrichtungen 14, wie die entsprechenden Greifereinheiten 15 des ersten und zweiten Bestückkopfes 10, 11, auf einer zur Längsachse 9-1 des ersten Trägerarmes 8 bzw. zur Transportrichtung parallelen Linie. Zur Aufnahme von Bauteilen werden der erste und zweite Bestückkopf 10, 11 in den jeweils zugeordneten Abholbereich 12, 13 zu den Zuführeinrichtungen 14 verfahren, wobei die Greifereinheiten 15 in Richtung zu den Zuführeinrichtungen 14 relativ zum Gehäuse 30 des Bestückkopfs abgesenkt werden und die Bauteile von den Abholpositionen entnehmen. Sich jeweils entsprechende Paare von Greifereinheiten 15 des ersten und zweiten Bestückkopfes 10, 11 nehmen dabei gleichartige Bauteile auf. Die Abstände der Zuführeinrichtungen 14 im ersten und zweiten Abholbereich 12, 13 sind derart aufeinander abgestimmt, dass jeweils entsprechende Paare von Greifereinheiten 15 des ersten und zweiten Bestückkopfes 10, 11 gleichartige Bauteile gleichzeitig von den Abholpositionen entnehmen können. Durch dieses gleichzeitige Aufnehmen der Bauteile ergibt sich ein erheblicher Zeitvorteil. Nach der Aufnahme der Bauteile werden die Bestückköpfe zur Transportstrecke 2 verfahren, um dort den Bestückvorgang vorzunehmen.

Ein erstes Substrat 16, welches dem ersten Bestückkopf 10 zugeordnet ist, und ein zweites Substrat 17, welches dem zweiten Bestückkopf 11 zugeordnet ist, werden entlang der Transportstrecke 2 zu den jeweiligen Bestückplätzen 18 transportiert. Im Folgenden wird davon ausgegangen, dass die Transportstrecke 2 mit dem zugehörigen Antrieb für die Substrate 16, 17 derart ausgebildet ist, dass das erste und zweite Substrat 16, 17 in eine bezüglich des ersten und zweiten Bestückkopfes 10, 11 gleiche relative Lage gebracht werden kann. Zu diesem Zweck können beispielsweise auf gegenüber liegenden Seiten der Transportstrecke 2 hydraulisch oder elektrisch betätigte Anschläge 19 (in Fig. 1b gestrichelt dargestellt) angeordnet sein, mittels welcher die Substrate 16, 17 quer zur Transportrichtung in eine definierte Lage gebracht werden können.

Ein Teilverfahren, um die Substrate 16, 17 auch in Transportrichtung auf einfache und präzise Weise in eine definierte Lage zu bringen, wird im Folgenden beschrieben.

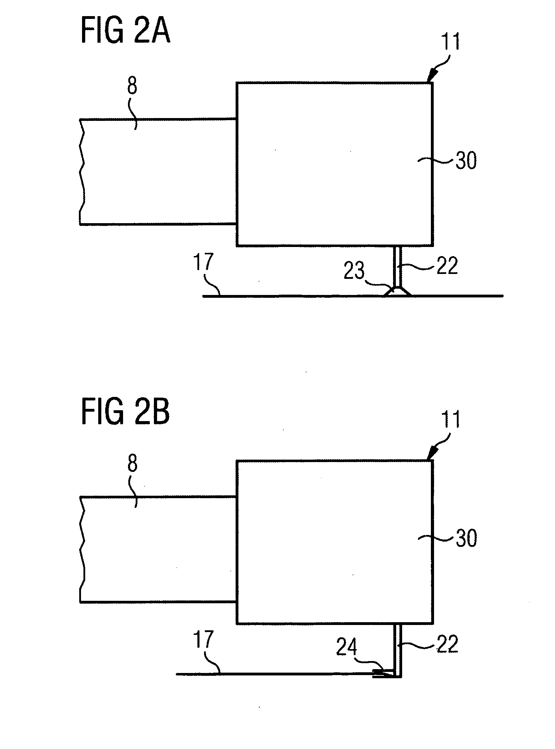

Der erste und zweite Bestückkopf 10, 11 können eine erste und zweite Führungseinrichtung 20, 21 aufweisen, welche relativ zu dem Gehäuse 30 des jeweiligen Bestückkopfes senkrecht zur Substratoberfläche (Pfeil z) bewegt werden können. Dabei kann es sich um einen einfachen Metallstift 22, oder, wie in den Figuren 2a und 2b dargestellt, um einen Metallstift 22 mit einem Saugnapf 23 oder einem zangenartigen Greifer 24 zum Erfassen und Halten des jeweiligen Substrats 16, 17 handeln. Im Ausführungsbeispiel nach den Figuren 1a und 1b fungieren jedoch jeweils eine der Greifereinheiten 15 des ersten und zweiten Bestückkopfes 10, 11 als erste und zweite Führungseinrichtung 20, 21.

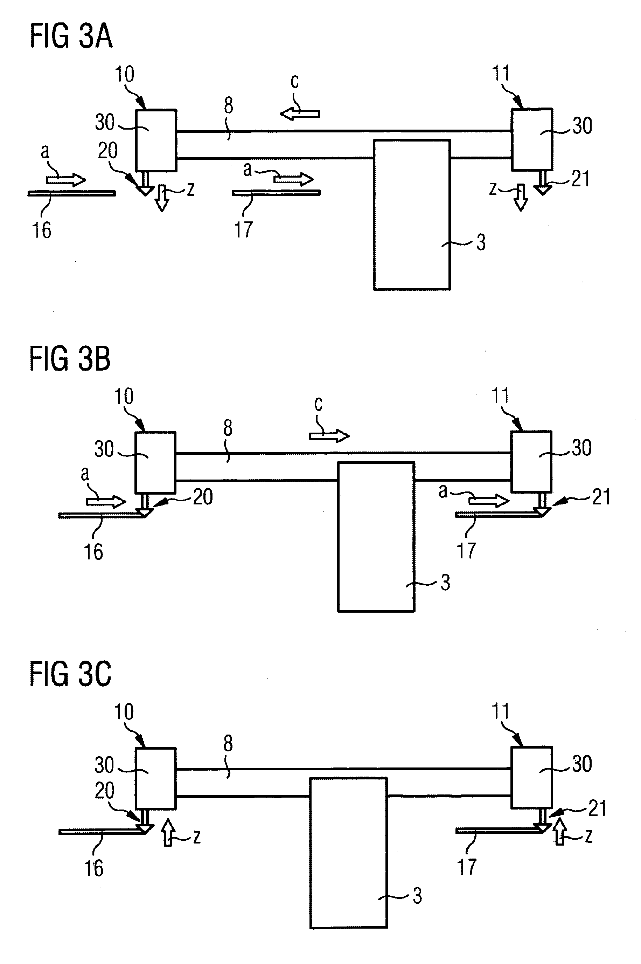

Wie in Figur 3a gezeigt, werden das erste und zweite Substrat 16, 17 entlang der Transportstrecke 2 mit einer gewissen Geschwindigkeit in Transportrichtung (Pfeil a) transportiert. Der erste Trägerarm 8 wird entgegen der Transportrichtung (Pfeil c), beispielsweise bis zu einem mechanischen Anschlag seines Antriebs, verfahren. Dies muss spätestens bis zu dem Zeitpunkt geschehen, an dem das erste oder zweite Substrat 16, 17 in Transportrichtung auf Höhe des jeweils zugeordneten Bestückkopfes angekommen ist. Die als erste und zweite Führungseinrichtungen 20, 21 fungierenden Greifereinheiten 15 des ersten und zweiten Bestückkopfes 10, 11 werden in Bestückrichtung (Pfeil z) soweit ausgefahren, dass sie sich in etwa auf Höhe der in Transportrichtung weisenden Vorderkanten der Substrate 16, 17 befinden.

Bevor das erste oder zweite Substrat 16, 17 die als erste und zweite Führungseinrichtungen 20, 21 fungierenden Greifereinheiten 15 des jeweils zugeordneten ersten und zweiten Bestückkopfes 10, 11 erreicht, wird der erste Trägerarm 8 in Transportrichtung mit etwas geringerer Geschwindigkeit als die Substrate 16, 17 auf der Transportstrecke 2 bewegt (siehe Figur 3b). Dadurch stoßen die Substrate 16, 17 zwangsläufig an die Greifereinheiten 15 des jeweils zugeordneten Bestückkopfes an und werden dadurch geringfügig abgebremst. Die Substrate 16, 17 bewegen sich ab diesem Moment genauso schnell wie der erste Trägerarm 8 unabhängig von der Geschwindigkeit des Transportbandes. Die Substrate 16, 17 werden auf diese Weise von den Greifereinheiten 15 bzw. Führungseinrichtungen 20, 21 zu den vorgegebenen Bestückpositionen geführt.

Bei Erreichen dieser Positionen wird der Antrieb des ersten Trägerarms 8 angehalten und die Substrate 16, 17 werden auf der Transportstrecke 2 durch die erste und zweite Führungseinrichtungen 20, 21 gestoppt (siehe Figur 3c). Außerdem wird der Transportmechanismus angehalten und die Greifereinheiten 15 bzw. die Führungseinrichtungen 20, 21 können wieder eingefahren werden.

Durch dieses Teilverfahren ist es möglich, die Substrate in einem präzise definierten Abstand zueinander auf der Transportstrecke 2 zu positionieren, so dass ein gleichzeitiges Bestücken der Substrate 16, 17 möglich ist. Ferner erlaubt dieses Verfahren die Verwendung der Greifereinheiten 15 als Führungseinrichtung 20, 21 für das jeweils zugeordnete Substrat 16, 17, ohne dabei die Greifereinheiten 15 zu beschädigen. Der Vorgang kann sowohl vor als auch nach dem Abholen der Bauteile durchgeführt werden.

Da die in den Figuren 2a und 2b dargestellten Ausgestaltungen der Führungseinrichtung 20, 21 wesentlich unempfindlicher gegen Beschädigung sind, muss das Teilverfahren gemäß den Figuren 3a bis 3c bei Verwendung dieser Führungseinrichtungen 20, 21 nicht notwendigerweise durchgeführt werden. In diesem Fall würde es genügen, den ersten Trägerarm 8 mit den Bestückköpfen derart zu positionieren, dass die Substrate 16, 17 hart an die Führungseinrichtung 20 anstoßen und so an der jeweils vorgegebenen Position entlang der Transportstrecke 2 angehalten werden.

Die in der Figur 2a dargestellte Führungseinrichtung 20, 21 weist einen Saugnapf 23 auf, welcher sich auf der Oberfläche des der Substrate 16, 17 anhaften kann. Bei der Ausgestaltung gemäß der Figur 2b weist die Führungseinrichtung 20 einen zangenartigen Greifer 24 auf, mit der die Vorderkante des Substrats 16, 17 erfasst und gehalten werden kann. Beide Ausführungen haben gemeinsam, dass mit ihnen die Substrate 16, 17 aktiv erfasst und zu der gewünschten Bestückposition aktiv transportiert werden kann, ohne auf die Bewegung der Transportstrecke 2 angewiesen zu sein. Dadurch können Geschwindigkeitsvorteile bei der Positionierung der Substrate 16, 17 erzielt werden.

Nach der Positionierung des ersten und zweiten Substrats 16, 17 ist deren relative Lage zu dem jeweils zugeordneten Bestückkopf gleich. In diesem Fall kann der Bestückvorgang beider Substrate 16, 17 simultan durchgeführt werden. Dies bedeutet, dass die entsprechenden Greifereinheiten 15 des ersten und zweiten Bestückkopfes 10, 11 gleichartige Bauteile an jeweils gleichen Positionen auf dem ersten und zweiten Substrat 16, 17 gleichzeitig absetzen. Dadurch wird ein erheblicher Geschwindigkeitsvorteil beim Bestücken erreicht.

Im Folgenden wird eine zweite Ausgestaltung des Verfahrens zum Bestücken von Substraten 16, 17 mit Bauteilen unter Verwendung des erfindungsgemäßen Bestücksystems näher beschrieben, wobei es sich bei dem Mechanismus der Transportstrecke 2 um eine einfache Ausgestaltung handelt, bei der eine seitliche Positionierung der Substrate 16, 17 quer zur Transportrichtung nicht ausreichend präzise durchgeführt werden kann, um diese in zu dem jeweils zugeordneten Bestückkopf 10, 11 gleiche relative Lagen gebracht werden können. Beispielsweise ist dies dann der Fall, wenn es sich bei dem Transportmechanismus um ein einfaches Transportband ohne seitliche Anschläge 19 handelt.

Ungeachtet dessen, kann der Abholvorgang der elektrischen Bauteile von dem ersten und zweiten Abholbereich 12, 13, wie im Rahmen der ersten Ausgestaltung des Verfahrens beschrieben, durchgeführt werden.

Auch der Vorgang der Positionierung der Substrate 16, 17 in Richtung der Transportrichtung kann, im Rahmen der ersten Ausgestaltung des Verfahrens beschrieben, durch die erste und zweite Führungseinrichtung 20, 21 der Bestückköpfe 10, 11 durchgeführt werden. Dadurch kann davon ausgegangen werden, dass die Lage der Substrate 16, 17 in Transportrichtung relativ zu den Bestückköpfen 10, 11 gleich sind. Geringe Abweichungen ergeben sich lediglich quer zur Transportrichtung. Es wird jedoch darauf hingewiesen, dass diese Abweichungen in der Regel relativ klein sind.

Die zweite Ausgestaltung des Verfahrens soll dazu dienen, auch bei derartig geringen Abweichungen den Bestückvorgang in möglichst geringer Zeit durchzuführen. Nach dem Aufnehmen der Bauteile werden die Bestückköpfe 16, 17 in den jeweiligen Bestückbereich verfahren. Zunächst wird der erste Bestückkopf 10 so oberhalb des ihm zugeordneten ersten Substrats 16 positioniert, dass eine Greifereinheit 15 des ersten Bestückkopfes 10 das Bauteil auf einer vorgegebenen Position auf dem ersten Substrat 16 absetzt. Dazu wird die Greifereinheit 15 in Bestückrichtung senkrecht auf das erste Substrat 16 bewegt. Unmittelbar, nachdem die Greifereinheit 15 des ersten Bestückkopfes 10 das Bauteil freigegeben hat, werden der erste und zweite Bestückkopf 10, 11 um einen geringen Korrekturbetrag bewegt, so dass die entsprechende Greifereinheit 15 des zweiten Bestückkopfes 11 an der entsprechend gleichen Position des zweiten Substrats 17 positioniert ist. Noch während der Korrekturbewegung wird die entsprechende Greifereinheit 15 des zweiten Bestückkopfes 11 zumindest teilweise in Bestückrichtung ausgefahren, so dass bei Erreichen der Bestückposition die dort zurückzulegende Strecke der Greifereinheit 15 minimiert ist. Während der Korrekturbewegung kann auch die Greifereinheit 15 des ersten Bestückkopfes 10, welche den vorhergehenden Bestückvorgang durchgeführt hat, in Richtung zum Gehäuse 30 des ersten Bestückkopfes entgegen der Bestückrichtung eingefahren werden. Da die Korrekturbewegungen sehr gering sind, laufen die Bestückvorgänge zweier entsprechender Greifereinheiten 15 des ersten und zweiten Bestückkopfes 10, 11 zwar nicht vollständig, aber dennoch nahezu gleichzeitig ab.

Wie aus den Figuren 1a und 1b hervorgeht, sind der erste und zweite Bestückkopf 10, 11 als Zeilen- bzw. Matrixkopf ausgebildet, bei dem die Greifereinheiten 15 zeilen- oder matrizenförmig in einer Ebene angeordnet sind. Es ist jedoch auch denkbar, so genannte Revolverbestückköpfe einzusetzen. Bei dieser Art von Bestückkopf sind die Greifereinheiten rotationssymmetrisch an einem drehbaren Rotor angebracht, welcher sich um eine stationäre Achse dreht. Bei Revolverbestückköpfen befindet sich nur eine Greifereinheit in einer Bestückposition, in welcher der Bestückvorgang durchgeführt werden kann. Bei Verwendung derartiger Bestückköpfe ist es möglich, dass, nachdem der erste Bestückkopf den Bestückvorgang abgeschlossen hat und die Korrekturbewegung einsetzt, der Rotor des ersten Bestückkopfs sich soweit dreht, dass sich die nächste Greifereinheit in der Bestückposition befindet. Dadurch kann der Bestückvorgang nach Abschluss des Aufsetzens des Bauteils durch die zweite Greifereinheit des zweiten Bestückkopfs sehr schnell fortgesetzt werden. Gleichzeitig können die Anforderungen an die Rotationsgeschwindigkeit der Bestückköpfe vermindert werden.

Bisher wurden Ausgestaltungen des Verfahrens zum Bestücken von Substraten beschrieben, bei denen die Bestückköpfe die zugeordneten Substrate zum Aufbau gleicher Baugruppen mit gleichen Bauteilen bestücken. Das Verfahren kann jedoch unter Verwendung des erfindungsgemäßen Bestücksystems auch derart ausgestaltet werden, dass der erste und zweite Bestückkopf 10, 11 ein Substrat nacheinander mit jeweils unterschiedlichen Bauteilen bestücken. In diesem Fall wird jedes Substrat nacheinander sowohl von dem ersten Bestückkopf 10 als auch von dem zweiten Bestückkopf 11 bestückt. Das Substrat wird von dem in Transportrichtung stromaufwärts angeordneten ersten Bestückkopf 10 mit kleineren Bauteilen bestückt, danach zum zweiten Bestückkopf 11, welcher sich stromabwärts befindet, bewegt und dort mit größeren Bauteilen bestückt. Die Bauteile, mit welchen der zweite Bestückkopf 11 bestückt, sind also durchwegs größer als diejenigen, mit welchen der erste Bestückkopf 10 bestückt. Dadurch wird verhindert, dass die Bauteile, welche vom ersten Bestückkopf 10 auf dem Substrat platziert wurden, von dem zweiten Bestückkopf 11 vom Substrat abgeräumt oder beschädigt werden.

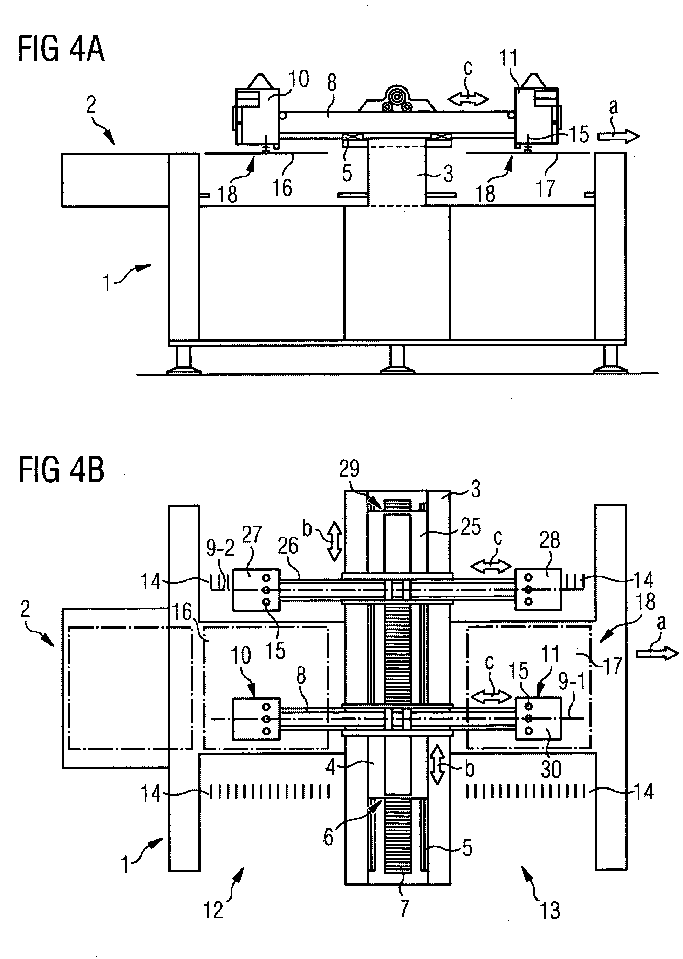

Wie aus den Figuren 4a und 4b hervorgeht, kann das Bestücksystem auch dahingehend erweitert werden, dass es einen zweiten Trägerschlitten 25, welcher an dem Grundträger 3 in der Verschieberichtung verschiebbar gelagert ist, einen lang gestreckten zweiten Trägerarm 26, dessen Längsachse 9-2 quer zur Verschieberichtung orientiert ist und welcher an dem zweiten Trägerschlitten 25 in Richtung seiner Längsachse 9-2 verschiebbar gelagert ist und einen dritten und einen vierten Bestückkopf 27, 28 aufweist, welche in Richtung der Längsachse 9-2 des zweiten Trägerarmes 26 auf gegenüberliegenden Seiten des zweiten Trägerschlittens 25 in einem festen Abstand zueinander am zweiten Trägerarm 26 angeordnet sind, umfasst. Im Ausführungsbeispiel der Figuren 4a und 4b ist also ein zweiter Trägerschlitten 25 mit einem zweiten Trägerarm 26 und einem dritten und vierten Bestückkopf 27, 28 zusätzlich am Grundträger 3 angebracht. Der zweite Trägerschlitten 25 wird mittels eines zweiten Linearmotors 29 angetrieben, wobei die Permanentmagnete 7 auf den Grundträger 3 gleichzeitig sowohl als Stationärteile für den ersten Linearmotor 6 des ersten Trägerschlittens 4 als auch für zweiten Linearmotor 29 des zweiten Trägerschlittens 25 dienen. Dadurch können Baugruppen zusammengefasst, Herstellungskosten reduziert und die Konstruktion des Bestücksystems vereinfacht werden. Die Bestückköpfe 27, 28 auf Seiten des zweiten Trägerarmes 26 müssen nicht unbedingt genauso angeordnet sein, wie am ersten Trägerarm 8 und auch nicht von derselben Art sein. Den Bestückköpfen 27, 28 des zweiten Trägerarmes 26 ist auf der gegenüberliegenden Seite der Transportstrecke 2 jeweils ein Zuführbereich mit Zuführeinrichtungen 14 zugeordnet. Durch diese doppelseitige Anordnung von Bestückköpfen 27, 28 an die Leistungsfähigkeit und auch die Flexibilität des Bestücksystems weiter erhöht werden, da mit einer größeren Vielfalt und mit höherer Geschwindigkeit die Substrate 16, 17 bestückt werden können.

Es ist anzumerken, dass der Grundträger 3 derart breit ausgebildet werden kann, dass darunter auf der Transportstrecke 2 zwischen den gerade zu bestückenden Substraten 16, 17 ein weiteres Substrat als Puffer angeordnet ist.

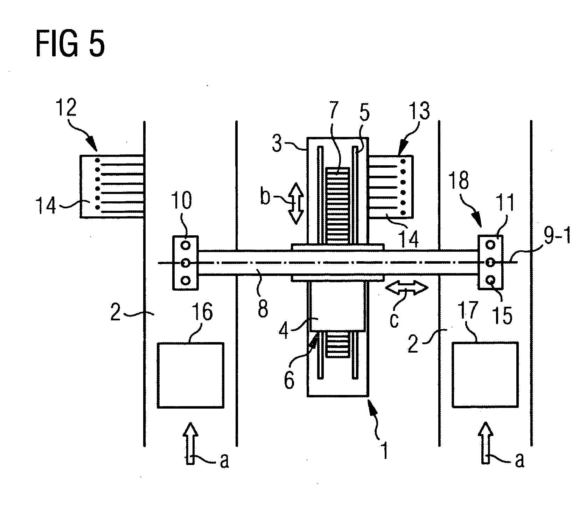

In der Figur 5 ist eine weitere Ausgestaltung des erfindungsgemäßen Bestücksystems dargestellt. Dabei werden die Substrate 16, 17 nicht auf einer gemeinsamen Transportstrecke 2 transportiert, sondern auf zwei nebeneinander parallel verlaufenden Transportstrecken 2. Der Grundträger 3 ist zwischen den beiden Transportstrecken 2 angeordnet und der erste Trägerschlitten 4 ist parallel (Pfeil b) zur Transportrichtung (Pfeil a) bewegbar. Die Längsachse 9-1 des ersten Trägerarmes 8 ist in diesem Fall senkrecht zur Transportrichtung gerichtet und der erste Trägerarm 8 ist bezüglich des ersten Transportschlittens 4 auch senkrecht zur Transportrichtung verschiebbar gelagert (Pfeil c). Seitlich jeder Transportstrecke 2 ist jedem Bestückkopf 10, 11 ein Zuführbereich zugeordnet. Grundsätzlich ist zu sagen, dass die oben beschriebenen Ausgestaltungen des Verfahrens zum Bestücken der Substrate mit gleichen Bauteilen analog mit dem Ausführungsbeispiel des erfindungsgemäßen Bestücksystems nach Figur 5 durchgeführt werden können.

Es ist auch darauf hinzuweisen, dass auch mehr als zwei Bestückköpfe oder andere Funktionseinrichtungen, wie Kameras und Klebeeinrichtungen, an dem ersten und zweiten Trägerarm 8, 26 angeordnet werden können. Dadurch wird die Flexibilität des Bestücksystems weiter verbessert.

### Bezugszeichenliste:

- 1: Chassis
- 2: Transportstrecke
- 3: Grundträger
- 4: erster Trägerschlitten
- 5: Linearführungen
- 6: erster Linearmotor
- 7: Permanentmagnete
- 8: erster Trägerarm
- 9-1: Längsachse des ersten Trägerarms
- 9-2: Längsachse des zweiten Trägerarms
- 10: erster Bestückkopf
- 11: zweiter Bestückkopf
- 12: erster Abholbereich
- 13: zweiter Abholbereich
- 14: Zuführeinrichtungen
- 15: Greifereinheiten
- 16: erstes Substrat
- 17: zweites Substrat
- 18: Bestückplätze
- 19: Anschläge
- 20: erste Führungseinrichtung
- 21: zweite Führungseinrichtung
- 22: Metallstift
- 23: Saugnapf
- 24: Zange
- 25: zweiter Trägerschlitten
- 26: zweiter Trägerarm
- 27: dritter Bestückkopf
- 28: vierter Bestückkopf
- 29: zweiter Linearmotor
- 30: Gehäuse

## Patentansprüche

1. Bestücksystem zum Bestücken von Substraten mit elektrischen Bauteilen, mit
- mindestens einer Transportstrecke (2), mittels der ein erstes und ein zweites Substrat (16, 17) in einer Transportrichtung transportierbar sind,
- einem Grundträger (3),
- einem ersten Trägerschlitten (4), welcher an dem Grundträger (3) in einer Verschieberichtung verschiebbar gelagert ist,
- einem lang gestreckten ersten Trägerarm (8), dessen Längsachse (9-1) quer zur Verschieberichtung orientiert ist und welcher an dem ersten Trägerschlitten (4) in Richtung seiner Längsachse (9-1) verschiebbar gelagert ist, und
- einem ersten Bestückkopf (10) und einem zweiten Bestückkopf (11) zum Bestücken von zumindest einem der ersten und zweiten Substrate (16, 17), wobei der erste und der zweite Bestückkopf (10, 11) in Richtung der Längsachse (9-1) des ersten Trägerarms (8) auf gegenüberliegenden Seiten des Trägerschlittens (4) in einem festen Abstand zueinander am ersten Trägerarm (8) angeordnet sind.

2. Bestücksystem nach Anspruch 1, wobei der erste und der zweite Bestückkopf (10, 11) derart ausgebildet und derart am ersten Trägerarm (8) angeordnet sind, dass das erste Substrat (16) von dem ersten Bestückkopf (10) und das zweite Substrat (17) von dem zweiten Bestückkopf (11) zur Bildung gleicher Baugruppen mit gleichen Bauteilen gleichzeitig bestückbar sind.

3. Bestücksystem nach einem der Ansprüche 1 bis 2, wobei der Grundträger (3) die Transportstrecke (2) quer überspannt, die Verschieberichtung des ersten Trägerschlittens (4) quer zur Transportrichtung gerichtet ist, und der erste Trägerarm (8) parallel zur Transportrichtung verschiebbar gelagert ist.

4. Bestücksystem nach einem der Ansprüche 1 bis 3, wobei der erste Bestückkopf (10) und der zweite Bestückkopf (11) jeweils an den Stirnseiten des ersten Trägerarms (8) angeordnet sind.

5. Bestücksystem nach einem der Ansprüche 1 bis 4, wobei an dem ersten Bestückkopf (10) eine erste Führungseinrichtung (20) und an dem zweiten Bestückkopf (11) eine zweite Führungseinrichtung (21) vorgesehen sind, mittels der das erste und zweite Substrat (16, 17) auf eine vorgegebene Position entlang der Transportstrecke (2) führbar sind.

6. Bestücksystem nach Anspruch (5), wobei die erste und die zweite Führungseinrichtung (20, 21) jeweils eine Halteeinrichtung (23, 24) zum Halten des jeweiligen Substrats (16, 17)aufweisen.

7. Bestücksystem nach einem der Ansprüche 1 bis 6, wobei an dem ersten Trägerarm (8) mehrere Funktionseinheiten angeordnet sind.

8. Bestücksystem nach einem der Ansprüche 1 bis 7, mit einer Vielzahl von Zuführeinrichtungen (14) zum Zuführen der elektrischen Bauteile, wobei die Zuführeinrichtungen (14) derart entlang der Transportstrecke (2) angeordnet sind, dass die elektrischen Bauteile durch den ersten und zweiten Bestückkopf (10, 11) gleichzeitig von den Zuführeinrichtungen (14) abholbar sind.

9. Bestücksystem nach Anspruch 1, mit einem zweiten Trägerschlitten (25), welcher an dem Grundträger (3) in der Verschieberichtung verschiebbar gelagert ist, einem lang gestreckten zweiten Trägerarm (26), dessen Längsachse (9-2) quer zur Verschieberichtung orientiert ist und welcher an dem zweiten Trägerschlitten (25) in Richtung seiner Längsachse (9-2) verschiebbar gelagert ist, und einem dritten Bestückkopf (27) und einem vierten Bestückkopf (28), welche in Richtung der Längsachse (9) des zweiten Trägerarms (26) auf gegenüberliegenden Seiten des zweiten Trägerschlittens (25) in einem festen Abstand zueinander am zweiten Trägerarm (26) angeordnet sind.

10. Bestücksystem nach Anspruch 9, wobei der erste Trägerschlitten (4) mittels eines ersten Linearmotors (6) und der zweite Trägerschlitten (25) mittels eines zweiten Linearmotors (29) am Grundträger (3) verschiebbar sind, und wobei am Grundträger (3) Permanentmagnete ((7)) als gemeinsame Stationärteile für den ersten und den zweiten Linearmotor (29) angeordnet sind.

11. Verfahren zum Bestücken von Substraten mit elektrischen Bauteilen unter Verwendung des Bestücksystems nach einem der Ansprüche 1 bis 8, wobei der erste und der zweite Bestückkopf (10, 11) jeweils mindestens eine Greifereinheit (15) aufweisen, welche relativ zu einem Gehäuse (30) des jeweiligen Bestückkopfs (10, 11) verfahren werden, und der erste und der zweite Bestückkopf (10, 11) einen Handhabungsvorgang für die Bauteile mittels der jeweiligen Greifereinheiten (15) durchführen.

12. Verfahren nach Anspruch 11, wobei das erste Substrat (16) dem ersten Bestückkopf (10) und das zweite Substrat (17) dem zweiten Bestückkopf (11) zugeordnet ist, und wobei zumindest eine Greifereinheit (15) des ersten Bestückkopfs (10) und eine Greifereinheit des zweiten Bestückkopfs (11) das jeweils zugeordnete Substrat (16, 17) zur Bildung gleicher Baugruppen mit gleichen Bauteilen gleichzeitig bestücken.

13. Verfahren nach Anspruch 11, wobei das erste Substrat (16) dem ersten Bestückkopf (10) und das zweite Substrat (17) dem zweiten Bestückkopf (11) zugeordnet ist, und wobei zumindest eine Greifereinheit (15) des ersten Bestückkopfs (10) und eine Greifereinheit (15) des zweiten Bestückkopfs (11) das jeweils zugeordnete Substrat (16, 17) zur Bildung gleicher Baugruppen mit gleichen Bauteilen unmittelbar aufeinander folgend bestücken.

14. Verfahren nach Anspruch 13, wobei zwischen dem Bestückvorgang der Greifereinheit (15) des ersten Bestückkopfs (10) und dem Bestückvorgang der Greifereinheit (15) des zweiten Bestückkopfs (11) und nach einem Freigeben des Bauteils durch die Greifereinheit (15) des ersten Bestückkopfs (10) der erste und der zweite Bestückkopf (10, 11) um einen Korrekturbetrag bewegt werden.

15. Verfahren nach Anspruch 14, wobei der erste und der zweite Bestückkopf (10, 11) um den Korrekturbetrag bewegt werden, während die erste Greifereinheit (15) entgegen einer Bestückrichtung relativ zu dem Gehäuse (30) des ersten Bestückkopfs (10) bewegt wird.

16. Verfahren nach einem der Ansprüche 14 bis 15, wobei die Greifereinheit (15) des zweiten Bestückkopfs (11) während der Korrekturbewegung in einer Bestückrichtung relativ zu dem Gehäuse (30) des zweiten Bestückkopfs (11) bewegt wird.

17. Verfahren nach einem der Ansprüche 11 bis 16, wobei vor dem Bestücken zumindest eine Greifereinheit (15) des ersten Bestückkopfs (10) und zumindest eine Greifereinheit (15) des zweiten Bestückkopfs (11) gleichzeitig die jeweiligen Bauteile von Zuführeinrichtungen (14) des Bestücksystems durch Absenken der Greifereinheiten (15) in Richtung der Zuführeinrichtungen (14) abholen.

18. Verfahren nach einem der Ansprüche 12 bis 17, wobei vor dem Bestücken
- das erste Substrat (16) und das zweite Substrat (17) entlang der Transportstrecke (2) in einer Transportrichtung transportiert werden und gleichzeitig der erste und zweite Bestückkopf (10, 11) in Transportrichtung bewegt werden,
- während die Substrate (16, 17) und die Bestückköpfe (10, 11) in Transportrichtung bewegt werden, eine erste Führungseinrichtung (20), welche an dem ersten Bestückkopf (10) vorgesehen ist, mit dem ersten Substrat (16) und eine zweite Führungseinrichtung (21), welche an dem zweiten Bestückkopf (11) vorgesehen ist, mit dem zweiten Substrat (17) derart in Kontakt gebracht werden, dass das erste und das zweite Substrat (16, 17) jeweils zu einer vorgegebenen Position entlang der Transportstrecke (2) geführt werden, und
- das erste Substrat (16) mittels der ersten Führungseinrichtung (20) und das zweite Substrat (17) mittels der zweiten Führungseinrichtung (21) gestoppt werden, nachdem das erste und zweite Substrat (16, 17) jeweils die vorgegebene Position erreicht haben.

19. Verfahren nach Anspruch 18, wobei eine Greifereinheit (15) des ersten Bestückkopfs (10) die erste Führungseinrichtung (20) und eine Greifereinheit (15) des zweiten Bestückkopfs (11) die zweite Führungseinrichtung (21) bilden.

20. Verfahren nach Anspruch 19, wobei Greifereinheiten (15) des erstem und zweiten Bestückkopfs (10, 11), welche die erste und zweite Führungseinrichtung (20, 21) bilden, das erste und zweite Substrat (16, 17) zur Bildung gleicher Baugruppen mit gleichen Bauteilen bestücken.

21. Verfahren nach einem der Ansprüche 11 bis 20, wobei der erste Trägerarm (8) vor einem Verschieben des ersten Trägerschlittens (4) derart an dem ersten Trägerschlitten (4) verschoben wird, dass Abstände zweier freier Enden des ersten Trägerarms (8) zu dem ersten Trägerschlitten (4) gleich sind.

22. Verfahren nach Anspruch 11, wobei der Grundträger (3) die Transportstrecke (2) quer überspannt, die Verschieberichtung des ersten Trägerschlittens (4) quer zur Transportrichtung gerichtet ist, der erste Trägerarm (8) parallel zur Transportrichtung verschiebbar gelagert ist, und wobei der in Transportrichtung stromaufwärts angeordnete Bestückkopf kleinere Bauteile handhabt wie der in Transportrichtung stromabwärts angeordnete Bestückkopf.

## Claims

1. Loading system for loading substrates with electrical components, with
- at least one transport line (2), by means of which a first substrate and a second substrate (16, 17) can be transported in a direction of transport,
- a basic carrier (3),
- a first carrier slide (4), which is moveably mounted on the basic carrier (3) in a direction of movement,
- an elongated first carrier arm (8) the longitudinal axis (9-1) of which is oriented transversely in relation to the direction of movement and which is mounted moveably on the first carrier slide (4) in the direction of its longitudinal axis (9-1), and
- a first loading head (10) and a second loading head (11) for loading at least one of the first or the second substrates (16, 17) with the first loading head and the second loading head (10, 11) being arranged at a fixed distance from each other on the first carrier arm (8) on opposite sides of the carrier slide (4) in the direction of the longitudinal axis (9-1) of the first carrier arm (8).

2. Loading system in accordance with claim 1, with the first loading head and the second loading head (10, 11) being embodied in such a way and arranged in such a way on the first carrier arm (8) that the first substrate (16) can be loaded at the same time by the first loading head (10) and the second substrate (17) by the second loading head (11) to build similar modules with the same components.

3. Loading system in accordance with one of the claims 1 to 2, with the basic carrier (3) extending across the transport line (2), the direction of movement of the first carrier slide (4) being aligned transversely in relation to the direction of transport and the first carrier arm (8) being mounted to allow movement in parallel to the direction of transport.

4. Loading system in accordance with one of the claims 1 to 3, with the first loading head (10) and the second loading head (11) being in each case arranged on the front ends of the first carrier arm (8).

5. Loading system in accordance with one of the claims 1 to 4, with provision having been made for a first guiding device (20) on the first loading head (10) and a second guiding device (21) on the second loading head (11) by means of which the first substrate and the second substrate (16, 17) can be guided to a given position along the transport line (2).

6. Loading system in accordance with claim (5), with the first guiding device and the second guiding device (20, 21) having, in each case, a holding device (23, 24) for holding the substrates (16, 17) in each case.

7. Loading system in accordance with one of the claims 1 to 6, with a plurality of functional units being arranged on the first carrier arm (8).

8. Loading system in accordance with one of the claims 1 to 7, with a plurality of feeding devices (14) to feed electrical components, with the feeding devices (14) being arranged in such a way along the transport line (2) that the electrical components can be collected at the same time by the first loading head and the second loading head (10, 11) from the feeding devices (14).

9. Loading system in accordance with claim 1, with a second carrier slide (25), which is moveably mounted on the basic carrier (3) in the direction of movement, an elongated second carrier arm (26), the longitudinal axis (9-2) of which is oriented transversely in relation to the direction of movement and which is moveably mounted on the second carrier slide (25) in the direction of its longitudinal axis (9-2), and a third loading head (27) and a fourth loading head (28), which are arranged at a fixed distance from each other on the second carrier arm (26) on opposite sides of the second carrier slide (25) in the direction of the longitudinal axis (9) of the second carrier arm (26).

10. Loading system in accordance with claim 9, with the first carrier slide (4) able to be moved by means of a first linear motor (6) and the second carrier slide (25) by means of a second linear motor (29) along the basic carrier (3), and with the basic carrier (3) having permanent magnets ((7)) as common stationary parts for the first linear motor and the second linear motor (29).

11. Method for loading substrates with electrical components by using the loading system in accordance with one of the claims 1 to 8, with the first loading head and the second loading head (10, 11) at least having one gripping unit (15) in each case, which is moved relative to a housing (30) of the respective loading heads (10, 11), and the first loading head and the second loading head (10, 11) carrying out a handling process for the components by means of the gripping units (15) in each case.

12. Method in accordance with claim 11, with the first loading head (10) being assigned to the first substrate (16) and the second loading head (11) to the second substrate (17), and with at least one gripping unit (15) of the first loading head (10) and one gripping unit of the second loading head (11) loading the substrate (16, 17) assigned in each case to build similar modules with the same components at the same time.

13. Method in accordance with claim 11, with the first loading head (10) being assigned to the first substrate (16) and the second loading head (11) to the second substrate (17), and with at least one gripping unit (15) of the first loading head (10) and one gripping unit (15) of the second loading head (11) loading the substrate (16, 17) assigned in each case to build similar modules with the same components in immediate succession.

14. Method in accordance with claim 13, with between the loading process of the gripping unit (15) of the first loading head (10) and the loading process of the gripping unit (15) of the second loading head (11) and after the release of the component by the gripping unit (15) of the first loading head (10) both the first loading head and the second loading head (10, 11) being moved by a correction amount.

15. Method in accordance with claim 14, with the first loading head and the second loading head (10, 11) being moved by a correction amount, while the first gripping unit (15) is moved against the loading direction relative to the housing (30) of the first loading head (10).

16. Method in accordance with one of the claims 14 to 15, with the gripping unit (15) of the second loading head (11) being moved during the correction movement in a loading direction relative to the housing (30) of the second loading head (11).

17. Method in accordance with one of the claims 11 to 16, with before loading at least one gripping unit (15) of the first loading head (10) and at least one gripping unit (15) of the second loading head (11) collecting at the same time the respective components from the feeding devices (14) of the loading system by lowering the gripping units (15) in the direction of the feeding devices (14).

18. Method in accordance with one of the claims 12 to 17, with before loading
- the first substrate (16) and the second substrate (17) being moved along the transport line (2) in a direction of transport and the first loading head and the second loading head (10, 11) at the same time being moved in a direction of transport,
- while the substrates (16, 17) and the loading heads (10, 11) are being moved in a direction of transport, a first guiding device (20), for which provision has been made on the first loading head (10) being, in each case, brought into contact with the first substrate (16) in such a way and a second guiding device (21) for which provision has been made on the second loading head (11) being, in each case, brought into contact with the second substrate (17) in such a way that the first substrate and the second substrate (16, 17) are guided along the transport line (2) to a given position in each case, and
- the first substrate (16) being stopped by means of the first guiding device (20) and the second substrate (17) by means of the second guiding device (21) after the first substrate and the second substrate (16, 17) have reached the given position in each case.

19. Method in accordance with claim 18, with a gripping unit (15) of the first loading head (10) forming the first guiding device (20) and a gripping unit (15) of the second loading head (11) forming the second guiding device (21).

20. Method in accordance with claim 19, with gripping units (15) of the first loading head and the second loading head (10, 11), which form the first guiding device and the second guiding device (20, 21), loading the first substrate and the second substrate (16, 17) to form similar modules with the same components.

21. Method in accordance with one of the claims 11 to 20, with the first carrier arm (8) before movement of the first carrier slide (4), being moved on the first carrier slide (4) in such a way that the distances between the two free ends of the first carrier arm (8) and the first carrier slide (4) are equal.

22. Method in accordance with claim 11, with the basic carrier (3) extending across the transport line (2), the direction of movement of the first carrier slide (4) being aligned transversely in relation to the direction of transport, the first carrier arm (8) being mounted moveably in parallel to the direction of transport, and with the loading head arranged upstream in the direction of transport handling the smaller components such as the loading head arranged downstream in the direction of transport.

## Revendications

1. Système de pose pour équiper des substrats de composants électriques, comportant
- au moins un trajet de transport (2) au moyen duquel un premier et un deuxième substrats (16, 17) peuvent être transportés dans un sens de transport,
- un support de base (3),
- un premier chariot porteur (4) qui est logé sur le support de base (3) de manière déplaçable dans un sens de déplacement,
- un premier bras porteur (8) allongé dont l'axe longitudinal (9-1) est orienté transversalement par rapport au sens de déplacement et qui est logé sur le premier chariot porteur (4) de manière déplaçable dans le sens de son axe longitudinal (9-1), et
- une première tête de pose (10) et une deuxième tête de pose (11) pour équiper au moins l'un des premier et deuxième substrats (16, 17), les première et deuxième têtes de pose (10, 11) étant disposées à une distance fixe l'une de l'autre sur le premier bras porteur (8) dans le sens de l'axe longitudinal (9-1) du premier bras porteur (8) sur des côtés opposés du chariot porteur (4).

2. Système de pose selon la revendication 1, les première et deuxième têtes de pose (10, 11) étant réalisées et disposées sur le premier bras porteur (8) de manière telle que le premier substrat (16) peut être équipé par la première tête de pose (10) et le deuxième substrat (17), par la deuxième tête de pose (11), simultanément, avec des composants identiques, pour constituer des ensembles identiques.

3. Système de pose selon l'une des revendications 1 à 2, le support de base (3) enjambant le trajet de transport (2) transversalement, le sens de déplacement du premier chariot porteur (4) étant transversal par rapport au sens de transport et le premier bras porteur (8) étant logé de manière déplaçable parallèlement au sens de transport.

4. Système de pose selon l'une des revendications 1 à 3, la première tête de pose (10) et la deuxième tête de pose (11) se trouvant chacune sur les faces frontales du premier bras porteur (8).

5. Système de pose selon l'une des revendications 1 à 4, un premier dispositif de guidage (20) étant prévu sur la première tête de pose (10) et un deuxième dispositif de guidage (21) étant prévu sur la deuxième tête de pose (11), au moyen duquel les premier et deuxième substrats (16, 17) peuvent être dirigés vers une position prédéterminée le long du trajet de transport (2).

6. Système de pose selon la revendication 5, les premier et deuxième dispositifs de guidage (20, 21) comportent chacun un dispositif de retenue (23, 24) pour tenir le substrat (16, 17) respectif.

7. Système de pose selon l'une des revendications 1 à 6, plusieurs unités fonctionnelles étant situées sur le premier bras porteur (8).

8. Système de pose selon l'une des revendications 1 à 7, avec une pluralité de dispositifs d'amenée (14) pour amener les composants électriques, les dispositifs d'amenée (14) étant disposés de manière telle le long du trajet de transport (2) que les première et deuxième têtes de pose (10, 11) peuvent enlever simultanément les composants électriques des dispositifs d'amenée (14).

9. Système de pose selon la revendication 1, comprenant un deuxième chariot porteur (25) qui est logé sur le support de base (3) de manière déplaçable dans le sens de déplacement, un deuxième bras porteur (26) allongé dont l'axe longitudinal (9-2) est orienté transversalement par rapport au sens de déplacement et qui est logé sur le deuxième chariot porteur (25) de manière déplaçable dans le sens de son axe longitudinal (9-2), et une troisième tête de pose (27) et une quatrième tête de pose (28) qui sont disposées à une distance fixe l'une de l'autre sur le deuxième bras porteur (26) dans le sens de l'axe longitudinal (9) du deuxième bras porteur (26) sur des côtés opposés du deuxième chariot porteur (25).

10. Système de pose selon la revendication 9, le premier chariot porteur (4) pouvant être déplacé au moyen d'un premier moteur linéaire (6) et le deuxième chariot porteur (25), au moyen d'un deuxième moteur linéaire (29) sur le support de base (3) et des aimants permanents (17) étant disposés sur le support de base (3) en tant que pièces stationnaires communes pour les premier et deuxième moteurs linéaires (29).

11. Procédé pour équiper des substrats de composant électriques moyennant l'utilisation du système de pose selon l'une des revendications 1 à 8, les première et deuxième têtes de pose (10, 11) comportant chacune au moins une unité de préhension (15) qui subit un déplacement relativement à un logement (30) de la tête de pose respective (10, 11) et les première et deuxième têtes de pose (10, 11) effectuant une opération de manipulation des composants au moyen des unités de préhension respectives (15).

12. Procédé selon la revendication 11, le premier substrat (16) étant affecté à la première tête de pose (10) et le deuxième substrat (17) étant affecté à la deuxième tête de pose (11), et au moins une unité de préhension (15) de la première tête de pose (10) et une unité de préhension de la deuxième tête de pose (11) équipant simultanément de composants identiques le substrat (16, 17), qui est affecté à chacune, pour constituer des ensembles identiques.

13. Procédé selon la revendication 11, le premier substrat (16) étant affecté à la première tête de pose (10) et le deuxième substrat (17) étant affecté à la deuxième tête de pose (11), et au moins une unité de préhension (15) de la première tête de pose (10) et une unité de préhension (15) de la deuxième tête de pose (11) équipant de manière directement successive de composants identiques le substrat (16, 17), qui est affecté à chacune, pour constituer des ensembles identiques.

14. Procédé selon la revendication 13, les première et deuxième têtes de pose (10, 11) sont mus, entre l'opération de pose de l'unité de préhension (15) de la première tête de pose (10) et l'opération de pose de l'unité de préhension (15) de la deuxième tête de pose (11) et après que l'unité de préhension (15) de la première tête de pose (10) a libéré le composant, d'une valeur de correction.

15. Procédé selon la revendication 14, les première et deuxième têtes de pose (10, 11) étant mus de la valeur de correction pendant que la première unité de préhension (15) est mue à l'encontre d'un sens de pose relativement au logement (30) de la première tête de pose (10).

16. Procédé selon l'une des revendications 14 à 15, l'unité de préhension (15) de la deuxième tête de pose (11) étant mue dans un sens de pose relativement au logement (30) de la deuxième tête de pose (11) pendant le mouvement de correction.

17. Procédé selon l'une des revendications 11 à 16, au moins une unité de préhension (15) de la première tête de pose (10) et au moins une unité de préhension (15) de la deuxième tête de pose (11), avant la pose, enlevant simultanément les composants respectifs de dispositifs d'amenée (14) du système de pose par descente des unités de préhension (15) en direction des dispositifs d'amenée (14).

18. Procédé selon l'une des revendications 12 à 17, avant la pose,
- le premier substrat (16) et le deuxième substrat (17) étant transportés le long du trajet de transport (2) dans un sens de transport et, en même temps, les première et deuxième têtes de pose (10, 11) étant mues dans le sens de transport
- pendant que les substrats (16, 17) et les têtes de pose (10, 11) sont mus dans le sens de transport, un premier dispositif de guidage (20) prévu sur la première tête de pose (10) étant mis en contact avec le premier substrat (16) et un deuxième dispositif de guidage (21) prévu sur la deuxième tête de pose (11) étant mis en contact avec le deuxième substrat (17) de manière telle que les premier et deuxième substrats (16, 17) sont dirigés chacun vers une position prédéterminée le long du trajet de transport (2) et
- le premier substrat (16) et le deuxième substrat (17) sont respectivement stoppés au moyen du premier dispositif de guidage (20) et du deuxième dispositif de guidage (21) après que les premier et deuxième substrats (16, 17) ont chacun atteint la position prédéterminée.

19. Procédé selon la revendication 18, une unité de préhension (15) de la première tête de pose (10) constituant le premier dispositif de guidage (20) et une unité de préhension (15) de la deuxième tête de pose (11) constituant le deuxième dispositif de guidage (21).

20. Procédé selon la revendication 19, des unités de préhension (15) des première et deuxième têtes de pose (10, 11) qui constituent les premier et deuxième dispositifs de guidage (20, 21) équipant les premier et deuxième substrats (16, 17) de composants identiques pour constituer des ensembles identiques.

21. Procédé selon l'une des revendications 11 à 20, le premier bras porteur (8) subissant un déplacement de manière telle sur le premier chariot porteur (4), avant un déplacement du premier chariot porteur (4), que les distances entre deux extrémités libres du premier bras porteur (8) et le premier chariot porteur (4) sont identiques.

22. Procédé selon la revendication 11, le support de base (3) enjambant transversalement le trajet de transport (2), le sens de déplacement du premier chariot porteur (4) étant orienté transversalement par rapport au sens de transport, le premier bras porteur (8) étant logé de manière déplaçable parallèlement au sens de transport, et la tête de pose située en amont dans le sens de transport manipulant des composants de plus petite taille que la tête de pose située en aval dans le sens de transport.
